# EUROPÄISCHE PATENTSCHRIFT

(11) **EP 3 615 842 B1**
(45) Veröffentlichungstag und Bekanntmachung des Hinweises auf die Patenterteilung: **14.04.2021**
(21) Anmeldenummer: 17728450.2
(22) Anmeldetag: 24.04.2017
(51) Int. Cl.: F16G 13/16

(54) **SYSTEM ZUR LEITUNGSÜBERWACHUNG IN EINER ENERGIEFÜHRUNGSKETTE**
SYSTEM FOR LINE MONITORING IN AN ENERGY CHAIN
SYSTÈME PERMETTANT DE SURVEILLER UNE CONDUITE OU UNE LIGNE DANS UNE CHAÎNE PORTE-CÂBLES

(43) Veröffentlichungstag der Anmeldung: 04.03.2020
(73) Patentinhaber: Igus GmbH, 51147 Köln (DE)
(72) Erfinder: KRISTA, Sebastian, 53773 Hennef (DE)
(74) Vertreter: Lippert Stachow Patentanwälte Rechtsanwälte
(86) Internationale Anmeldenummer: PCT/EP2017/059685
(87) Internationale Veröffentlichungsnummer: WO 2018/196949

(56) Entgegenhaltungen:
- EP-A1- 2 814 041
- DE-U1-202016 000 501
- JP-A- 2009 052 714

## Beschreibung

Die Erfindung betrifft allgemein ein System zur Lage- und/oder Leitungsüberwachung in einer Energieführungskette. Die Erfindung betrifft speziell ein Überwachungssystem für eine Energieführungskette, die zum dynamischen Führen mindestens einer Leitung, wie z.B. eines Kabels, Schlauchs oder dergleichen, zwischen einer Basis und einemdazu relativbeweglichen Mitnehmer dient. Ein gattungsgemäßes System umfasst dabei einerseits eine Energieführungskette die entlang eines Verfahrwegs verfahrbar ist und dabei variabel, je nach Mitnehmerposition, ein bewegliches Trum mit einem Anschlussende für den Mitnehmer, ein ruhendes Trum mit einem Anschlussende für die Basis und zwischen beiden Trumen einen Umlenkbogen bildet. Andererseits umfasst das System eine Überwachungsvorrichtung mit mindestens einem an der Energieführungskette angeordneten Geber, wobei die Überwachungsvorrichtung ein anhand des Gebers erzeugtes Signal auswertet um zu überwachen, ob im Betrieb der Energieführungskette ein Fehlerzustand auftritt.

Unterschiedliche Systeme dieser Art sind bereits bekannt. So offenbaren z.B. die Patentanmeldungen WO 2004/090375 A1 und WO 2013/156607 A1 Systeme mit einem Kraftaufnehmer zwischen dem Mitnehmer und der Energieführungskette, um zu überwachen, ob die auftretenden Kräfte innerhalb eines Toleranzbereichs liegen.

Die Patentanmeldung WO 2015/118143 A1 offenbart ein System mit einem mechanisch wirkenden Geber, der anhand einer Auslöseschnur eine Beschädigung der Energieführungskette erfasst. Ein ähnliches System ist aus der JP 2009 052 714 A bekannt, wobei hier ein Brucherkennungssystem mit einer optischen Faser vorgeschlagen wird, d.h. anhand der Lichtmenge kann ein Bruch erkannt werden.

Die vorgenannten Systeme haben den Nachteil, dass sie grundsätzlich nur eine bereits eingetretene Beschädigung erkennen. Sie erlauben damit insbesondere keine prospektive Instandhaltung bzw. vorausschauende Wartung (Engl. predictive maintenance).

Ein Überwachungssystem das zustandsorientierte Instandhaltung erlauben kann wurde in der Patentanmeldung EP 1 521 015 A2 beschrieben. Hierbei wird z.B. anhand elektromechanisch wirkender Verschleißelemente der Abnutzungsgrad der Energieführungskette lokal begrenzt ermittelt, z.B. abnutzungsbedingter Verschleiß an der Schmalseite eines Kettenglieds. Dieses System liefert jedoch keine Information über die aktuelle Lage der Energieführungskette oder über den Zustand einer geführten Leitung.

In DE 20 2016 000 501 U1 hat die Anmelderin ein weiterentwickeltes System zur Zustandsüberwachung einer Energieführungskette vorgeschlagen, welche entlang eines Verfahrwegs verfahrbar ist und dabei ein bewegliches Trum mit einem Anschlussende für den Mitnehmer, ein ruhendes Trum mit einem Anschlussende für die Basis und zwischen beiden Trumen einen Umlenkbogen bildet. Dieses System hat eine Überwachungsvorrichtung mit einem oder mehreren an der Energieführungskette angeordneten Gebern, nämlich mit Funkmodulen zur Verschleißerkennung, und wertet deren Signal aus um zu überwachen, ob im Betrieb der Energieführungskette ein Fehlerzustand auftritt.

Es ist auch bereits bekannt, die zu erwartende Lebensdauer von Kabeln in Energieführungsketten anhand von Laborversuchen zu bestimmen aufgrund eines charakteristischen Anstiegs des Leiterwiderstands, der typisch erst nach vielen Hunderttausenden bzw. Millionen Testzyklen eintritt.

Schließlich ist aus dem Patent US 7,023,217 B1 in diesem Zusammenhang bereits ein Überwachungssystem bekannt, das es erlaubt, eine Erfassung des Verschleißzustands elektrischer Leiter, insbesondere von Flachbandkabeln, z.B. in einem Kabelschlepp zu realisieren. Hierbei werden mehrere Leiter des Flachbandkabels anhand einer aufwendigen Schaltungsanordnung mit einem Relais-Multiplexer und einem Präzisions-Voltmeter durchgemessen. Durch die aufwendige Schaltungsanordnung und die vorgeschlagene Anschlusstechnik an beiden Anschlussenden der Energieführungskette ist diese Lösung für einen Einsatz im praktischen bzw. aktiven Betrieb einer Energieführungskette jedoch wenig tauglich.

Eine erste Aufgabe der vorliegenden Erfindung besteht mithin darin, ein für den laufenden Betrieb geeignetes Überwachungssystem vorzuschlagen, das eine frühzeitige Erkennung von Verschleiß, insbesondere vor einem Leitungsbruch, erlaubt. Das Überwachungssystem soll insbesondere die prospektive bzw. vorausschauende Instandhaltung ermöglichen um Ausfallzeiten zu verringern oder ganz zu vermeiden. Es soll möglichst einfach aufgebaut sein und den Betrieb nicht nennenswert beeinträchtigen. Diese erste Aufgabe wird durch ein System nach Anspruch 1 gelöst.

Gemäß einem ersten Aspekt wird ein Überwachungssystem zur Zustandsüberwachung eines Kabels in einer Energieführungskette vorgeschlagen.

Zur Lösung der eingangs genannten Aufgabe wird in einem System nach dem Oberbegriff aus Anspruch 1 erfindungsgemäß vorgeschlagen, dass der Geber zwei von der Energieführungskette geführte elektrische Indikatorleiter aufweist, die entlang einer überwiegenden Länge des beweglichen Trums oder z.B. der Gesamtlänge verlaufen und dass die Überwachungsvorrichtung eine Schaltung mit einer Messeinrichtung zur Widerstands- oder Leitwertmessung umfasst. Ferner sieht der erste Aspekt vor, dass jeweils ein proximaler Endpunkt von jedem der beiden Indikatorleiter, d.h. die Endpunkte an einem der beiden Anschlussenden der Energieführungskette, mit der Messeinrichtung verbunden sind und die jeweils anderen bzw. distalen Endpunkte der beiden Indikatorleiter kurzgeschlossen sind. Diese Endpunkte der beiden Indikatorleiter können an einer bestimmten Längsposition der Energieführungskette enden oder vorzugsweise an dem anderen distalen Anschlussende der Energieführungskette. Durch den Kurzschluss bilden die Leiter eine Messschleife, deren Widerstands- oder Leitwert durch die Messeinrichtung messbar ist. Denkbar ist z.B. eine durchgehende Messschleife ohne Unterbrechung durch ein gesonderte Kurzschlusskomponente, d.h. dass der eine Indikatorleiter die Strecke hin bzw. von proximal zu distal und der andere Indikatorleiter Strecke zurück bzw. umgekehrt darstellt. Eine separate Kurzschlusskomponente ist jedoch praxistauglicher, da dies die Verwendung bestehender mehradriger Kabel erlaubt und keine durchgehende Messschleife erfordert.

Der Kerngedanke besteht soz. darin, dass die Schaltung eine Messeinrichtung zur Messung eines Widerstands- oder Leitwerts des Indikatorleiters umfasst und dass der Indikatorleiter in Form einer Schleife ausgeführt ist, sodass einseitig an demselben Anschlussende der Energieführungskette gemessen werden kann. Zudem wird durch den Verlauf hin und zurück der gemessene Widerstandswert erhöht und die verschleißbedingte Einwirkung annähernd verdoppelt, was eine zuverlässige Früherkennung vor einem Ader- bzw. Litzenbruch vereinfacht.

In bevorzugter Weiterbildung des ersten Aspekts ist vorgesehen, dass die Überwachungsvorrichtung eine Auswertungseinheit umfasst, die eine integrierte Logikschaltung und einen Referenzwertspeicher aufweist. Dabei kann die Logikschaltung ein Ausgangssignal der Messeinrichtung erhalten und zum Vergleich mit mindestens einem vorgespeicherten Referenzwert aus dem Referenzwertspeicher nutzen.

Die Auswertungseinheit erlaubt dabei die anwendungsspezifische modulare Anpassung der Überwachungsvorrichtung, auch bei gleichbleibender Topologie der Erfassungsschaltung, z.B. durch geeignetes Programmieren der Auswertungsfunktionen und/oder variable Speicherung der Betriebsparameter in der Auswertungseinheit. Die Auswertungseinheit ermöglicht dabei u.a. auch ein modular aufgebautes System mit mehreren Schaltungsmodulen, welche je nach dem gewünschten Überwachungsaspekt jeweils baugleich und unabhängig vom verwendeten Indikatorleiter ausgeführt sind, z.B. einen Schaltungstyp für die Lageüberwachung und einen Schaltungstyp für die Leitungsüberwachung. Zudem wird die flexible Berücksichtigung diverser Variablen, wie anwendungs- und laufzeitabhängiger Parameter sowie von Umgebungsparametern, z.B. Länge der Energieführungskette, Krümmungsradius, Zyklenanzahl, Temperatur usw. erleichtert. Die Erfassungsschaltung und die Auswertungseinheit können als Module in eine gemeinsame Baugruppe, ggf. auch auf einer Leiterplatte, integriert sein oder räumlich getrennt ausgeführt sein.

Insbesondere zur Realisierung einer echten Messung bzw. messtechnischen Erfassung der elektrischen Größe ist es vorteilhaft, wenn die Schaltung eine eingangsseitig mit dem Indikatorleiter verbundene Messeinrichtung umfasst, um die elektrische Größe, insbesondere einen elektrischen Parameter des Indikatorleiters, durch quantitative Messung zu erfassen und ausgangsseitig ein davon abhängiges Signal für die Auswertungseinheit bereitzustellen. Der Begriff Messung kann dabei im Sinne der Definition in der DIN-Norm DIN 1319 verstanden werden.

Insbesondere aber nicht nur im Fall einer messtechnischen Erfassung kann die Auswertungseinheit eine integrierte Logikschaltung aufweisen, wie z.B. einen Mikrocontroller oder dgl., mit einem Referenzwertspeicher zur Auswertung der erfassten bzw. gemessenen Größen in Bezug auf einen oder mehrere Referenzwerte, z.B. einen Toleranzbereich. Dabei kann die Messeinrichtung beliebig ausgeführt sein, wahlweise voll analog, teilanalog und teildigital oder rein digital ausgeführt. Aufgrund der vorzugsweise programmierbaren Logikschaltung kann die Auswertungseinheit modular und wahlweise an die Messschaltung anpasst werden. Der Referenzwertspeicher kann auch getrennt von der eigentlichen Auswertungseinheit ausgeführt sein, z.B. wenn letztere den ersteren bedarfsweise abfragt, ist aber vorzugsweise Teil der Logikschaltung.

Die modulare Bauweise erlaubt z.B. - unabhängig vom eingesetzten Indikatorleiter - eine anwendungsangepasste Widerstands- oder Impedanz-Messung. Da der Absolutwert u.a. von der Gesamtlänge des Indikatorleiters abhängt, welche zumindest entlang einer überwiegenden Länge des beweglichen Trums verlaufen soll, d.h. sind die zu erwartenden Messwerte stark von der Anwendung abhängig, in der die Energieführungskette eingesetzt wird. Durch laufende Widerstands- oder Impedanzmessung kann z.B. ein bevorstehender Ausfall von Adern durch Ermüdungsbruch in einem elektrischen Kabeln relativ zuverlässig vorhergesagt werden, wie weiter unten zum ersten Aspekt aufgezeigt. Anders als z.B. in US 7,023,217 B1 vorgeschlagen, ist es aber mit der vorgeschlagenen Auswertungseinheit nicht nötig, eine redundante inaktive Energieführungskette bzw. Leitung allein zu Referenzzwecken vorzusehen.

Der mindestens eine Indikatorleiter erstreckt sich vorzugsweise zumindest über einen überwiegenden Längenanteil der Energieführungskette, insbesondere über den gesamten im Betrieb verfahrbaren Längenanteil der Energieführungskette. Vorzugsweise erstreckt sich der Indikatorleiter dabei zumindest über die dem Mitnehmer nahe befindliche bzw. an diesen anschließende Hälfte der Länge der Energieführungskette, da hier durch Zug- und Schubkraft bedingte Beanspruchung der Verschleiß meist am größten ist und atypisches Verhalten dort am häufigsten auftritt. Der Indikatorleiter soll sich dabei zumindest über den kritischen Längsabschnitt der Energieführungskette erstrecken, typisch das erste Drittel vom Mitnehmer aus betrachtet.

Der elektrische Indikatorleiter kann separat, als zusätzliche Leitung, oder vorzugsweise als Bestandteil, eines in der Anwendung genutzten Kabels ausgeführt sein. Der Indikatorleiter ist in beiden Fällen vorzugsweise auf die gleiche Weise wie eine aktive Leitung und in der Energieführungskette geführt, insbesondere durchgehend von einem Ende der Energieführungskette zum anderen und ggf. auch in Form einer Schleifenform wieder zurück zum einen Ende.

Die Schaltung bzw. Messeinrichtung dazu kann insbesondere zur Spannungsmessung in Vierleitertechnik, ähnlich dem Prinzip einer Thomson-Brücke (auch Kelvin-Brücke genannt), ausgeführt sein mit einem in Vierleitertechnik eingebauten Referenzwiderstand, einem Differenzverstärker und einem Analog-Digital-Umsetzer ausgeführt sein, um auch kleinere Widerstandswerte einer Indikatorleitung präzise zu erfassen. Eine derartige Weiterbildung sieht z.B. vor, dass für die bzw. jede Messschleife ein eigener separater Instrumentenverstärker vorgesehen ist, welcher eingangsseitig mit beiden Endpunkten der Indikatorleiter verbunden ist, und ausgangsseitig mit einem Analog-Digital-Umsetzer, insbesondere einem in der Logikschaltung integrierten Analog-Digital-Umsetzer, verbunden ist. Vorzugsweise ist in Serie zu der bzw. den Messschleife(n) ein Referenzwiderstand geschaltet, wobei eine Konstantstrom-Quelle einen Messstrom durch die Messschleife(n) und ggf. Referenzwiderstand speist. Anhand des Referenzwiderstands kann die Spannungsmessung in Vierleitertechnik, ähnlich dem Prinzip einer Thomson-Brücke, auch einen sehr kleinen Widerstand der Messschleife aus den beiden Indikatorleitern hinreichend präzise erfassen.

Vorzugsweise ist die durch den zweiteilig hin- und zurückgeführten Indikatorleiter gebildete Messschleife anhand von zwei eigens dazu zweckbestimmten bzw. zugeordneten, zusätzlich Messadern in einem aktiven mehradrigen Versorgungskabel gebildet, dessen restliche Adern dem eigentlichen Versorgungszweck, z.B. der Datenübertragung oder Stromversorgung, dienen.

Die dedizierten Messadern sind vorzugsweise mittels einer Kurzschlusskomponente am mitnehmerseitigen Ende kurzgeschlossen und am basisseitigen Ende an die Messeinrichtung der Schaltung angeschlossen, d.h. die Schaltung und ggf. die Auswertungseinheit können einfach am stationären Teil der Anlage angeordnet sein. Die Beschaltung kann ggf. auch umgekehrt ausgeführt sein, wenn die Schaltung mitnehmerseitig vorgesehen ist, was insbesondere für ein am verfahrbaren Maschinenteil angeordnete Auswertungseinheit sinnvoll ist.

Für die Zustandsüberwachung eines Kabels ist es besonders vorteilhaft wenn die Messadern, welche den wesentlichen Teil der Indikatorleiter bilden, zusammen mit anderen aktiven Adern in einem im Betrieb bestimmungsgemäß eingesetzten Versorgungskabel verseilt oder ggf. verflochten sind. Hierdurch wird die Aussagekraft der Erfassung möglichst realitätsnah an die Abnutzung der eigentlich zu überwachenden aktiven Adern angeglichen. Dabei können die Messadern insbesondere baugleich zu mindestens einer im Betrieb aktiven Ader ausgeführt und auf analoge Weise wie diese verseilt bzw. eingeflochten sein. Insbesondere können die Messadern baugleich zu der auf Verschleiß anfälligsten Ader ausgeführt sein. Bei Leitungen mit einem großen Querschnitt ist es auch denkbar die Messadern mit kleinerem Leiterquerschnitt auszuführen und auf den Zustand einer stärkeren Hauptader zu interpolieren, insbesondere anhand der Auswertungseinheit.

Vorzugsweise hat die integrierte Logikschaltung oder, besonders bevorzugt, die Auswertungseinheit einen Bedieneingang zum Einspeichern eines bei Inbetriebnahme durch die Messeinrichtung gemessenen Widerstands- oder Leitwerts als Referenzwert. Dadurch kann auf einfache Weise auch durch den Endnutzer selbst der Normalwert für den ursprünglichen bzw. verschleißfreien Zustand der Messschleife bzw. der Indikatorleiter definiert werden. Hierdurch wird inhärent die Überwachungsvorrichtung anwendungsspezifisch programmiert, ohne dass z.B. die Länge der Energieführungskette oder ähnliche Daten bekannt sein müssen.

Insbesondere in Verbindung mit dem letztgenannten Merkmal ist es vorteilhaft wenn die Auswertungseinheit programmiert ist, um eine Warnmeldung auszulösen wenn der Widerstands- oder Leitwert des Indikatorleiters um einen vorbestimmten Betrag, insbesondere einen Betrag im Bereich von 15-25% des Referenzwerts, vom Referenzwert abweicht. Durch einen empirisch ermittelten Betrag als Schwellwert kann allein mit Kenntnis des ursprünglichen Normalwerts für den Widerstands- oder Leitwert die Kabelüberwachung erfolgen.

Für alle vorstehenden Aspekte, d.h. auch für Lageüberwachung und/oder Leitungszustandsüberwachung, sind die nachfolgenden Weiterbildungen vorteilhaft.

Die Auswertungseinheit weist vorzugsweise einen Speicher für Anwendungsdaten auf, und umfasst eine Logik, welche das von der Schaltung ausgegebene Signal abhängig von gespeicherten Anwendungsdaten auswertet. Diese Bauweise erlaubt z.B. das Anlernen von Nominalwerten oder eines Toleranzfelds. So können Referenzdaten z.B. in einem Initialisierungsprozess bei normalem, bestimmungsgemäß Verfahren einer neuen Energieführungskette mit der Schaltung aufgenommen und in der Auswertungseinheit gespeichert werden. Die anwendungs- und/oder lagespezifischen Referenzdaten können z.B. auch aus einem Testlabor gewonnen und in der Auswertungseinheit vorgespeichert oder zu dieser übertragen werden.

Insbesondere im letztgenannten Fall kann die Auswertungseinheit einen Eingang aufweisen, über den die aktuelle Position des Mitnehmers erfasst wird. Dies erlaubt es einen positionsabhängig aktuell geltenden Referenzwert aus dem Speicher zu lesen, was insbesondere für geometriesensitive Größen von Bedeutung ist.

Die Auswertungseinheit kann eine Kommunikationsschnittstelle, bspw. eine WLAN-Schnittstelle, zur Verbindung mit einem übergeordneten System umfassen, um Daten einzulesen oder zu senden, z.B. zur Initialisierung, zu Wartungszwecken oder zur Datensammlung beim Hersteller.

Insbesondere für eine präzise Messtechnische Erfassung ist es vorteilhaft wenn die Überwachungsvorrichtung einen Temperatursensor zur Temperaturnormierung aufweist. Dieser kann z.B. als Bestandteil einer modular ausgeführten Auswertungseinheit vorgesehen sein.

Zur Steigerung der Modularität kann die Vorrichtung, als Teil der Schaltung oder der Auswertungseinheit eine Logikschaltung aufweisen, insbesondere einen Mikrocontroller, ASIC, DSP oder dgl., welche die erfasste elektrische Größe digital verarbeitet, insbesondere zum Vergleich mit einem Referenzwert aus einem Referenzwertspeicher. Dies ist insbesondere vorteilhaft, wenn die Schaltung die elektrische Größe analog erfasst.

Die Schaltung kann im laufenden Betrieb der Energieführungskette die elektrische Größe zeitkontinuierlich oder zeitdiskret in gleichmäßigen oder zufälligen Zeitabständen erfassen. Hierbei ist vorzugsweise ein Filter, insbesondere ein Mittelwert- oder Spitzenfilter, in der Schaltung oder der Auswertungseinheit vorgesehen, um irrelevante Schwankungen z.B. durch elektromagnetische Störungen und dgl. herauszufiltern.

Die Vorrichtung kann, insbesondere als Modul, ortsfest an der Basis angeordnet sein, wobei der Indikatorleiter einseitig am Anschlussende für die Basis an die Schaltung angeschlossen ist.

Das Grundprinzip des hier vorgeschlagenen Überwachungssystems eignet sich für den laufenden Betrieb, sowohl zur Überwachung des räumlichen Verlaufs der Energieführungskette im laufenden Betrieb als auch zur Zustandsüberwachung eines Daten- oder Stromversorgungskabels einer Energieführungskette im fortdauernden Betrieb. Die Systeme dienen insbesondere präventiver Wartung und/oder der Sicherheitsabschaltung.

Weitere vorteilhafte Merkmale und Wirkungen der Erfindung werden im Folgenden anhand einiger bevorzugter Ausführungsbeispiele unter Bezugnahme auf die beigefügten Zeichnungen näher erläutert. Dabei zeigen:
FIG.1A-1B: als Prinzipskizze in Seitenansicht (FIG.1A) und schematischem Querschnitt (FIG.1B) eines Überwachungssystems;
FIG.2A-2B: als Prinzipskizze in Seitenansicht (FIG.2A) und schematischem Querschnitt (FIG.2B) eines Überwachungssystems gemäß einer Variante;
FIG.3: ein Schema eines Toleranzfelds innerhalb dessen eine an am Indikatorleiter elektrische Größe liegen soll;
FIG.4: als Prinzipskizze in Seitenansicht ein drittes Ausführungsbeispiel eines Überwachungssystems;
FIG.5: als Prinzipskizze in Seitenansicht ein viertes Beispiel eines Überwachungssystems gemäß einer weiteren Variante, mit einer drahtlosen Kommunikationsschnittstelle zu einem Kommunikationsmodul;
FIG.6A-6B: als Prinzipskizze in Seitenansicht (FIG.6A) ein erfindungsgemäßes Ausführungsbeispiel eines Überwachungssystems gemäß einem weiteren Aspekt, mit drahtloser Kommunikationsschnittstelle zu einem Kommunikationsmodul, und als separates Schaltungsmodul (FIG.6B) zur Zustandsüberwachung eines Kabels das in einer Energieführungskette; und
FIG.7: ein Foto eines teilweise freigelegten elektrischen Versorgungskabels mit verseilten Adern.

In allen Zeichnungen bezeichnen gleiche Bezugszeichen Merkmale mit gleichwertiger Beschaffenheit oder Wirkung. Zur Erleichterung werden Wiederholungen vermieden.

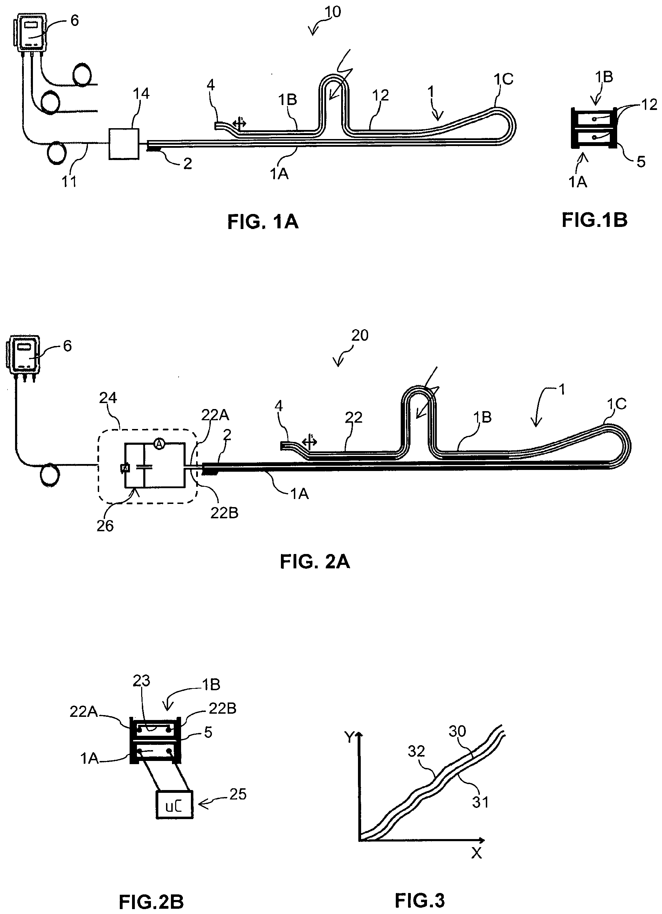

In den FIG.1-7 ist eine Energieführungskette, allgemein mit 1 bezeichnet, gezeigt mit einem liegenden stationären Trum 1A, bei horizontaler Anordnung auch Untertrum genannt, einen beweglichen Trum 1B, bei horizontaler Anordnung auch Obertrum genannt, sowie mit - als ortsvariablem Übergang dazwischen - einem verfahrbaren, etwa U-förmigen Umlenkbogen 1C der einen vordefinierten Krümmungsradius gewährleistet. Hier ist eine sog. "gleitende", d.h. nicht freitragende Energieführungskette 1 für lange Verfahrwege, typisch >3m gezeigt. Bei derartigen Energieführungsketten 1 kann das bewegliche Trum 1B auf dem stationären Trum 1A abgleiten oder abrollen. An sich bekannte Gleitkufen oder Gleitrollen sind nicht gezeigt. Dabei ist der vordefinierte Krümmungsradius des Umlenkbogens 1C, zum Schutz der geführten Leitungen (nicht gezeigt), deutlich größer als der Kontaktabstand zwischen den Trumen 1A, 1B. Die Erfindung eignet sich jedoch prinzipiell auch für freitragende Energieführungsketten oder vertikale Anwendungen (nicht gezeigt).

Der Endbereich des stationären Trums 1A bildet eine erste Anschlussstelle der Energieführungskette 1 und ist an einer zur Umgebung raumfesten Basis befestigt, welche den Festpunkt 2 der Energieführungskette 10 bildet. Der Endbereich des beweglichen Trums 1B bildet eine zweite Anschlussstelle der Energieführungskette 1 und ist an einem Mitnehmer 4 befestigt, der relativ zum Festpunkt 2 beweglich ist, nämlich mit dem zu versorgenden, bewegenden Teil, z.B. von einer Industriemaschine oder -Anlage verbunden ist.

In an sich bekannter Weise bewegt sich der Mitnehmer 4, gemäß den in FIG.1-7 eingezeichneten Doppelpfeilen in eine Vorwärts- und Rückwärtsrichtung und zieht bzw. schiebt dabei die Energieführungskette 1. In FIG.1-7 ist der Mitnehmer 4 und damit die Stellung der Energieführungskette 10 rein beispielhaft, nur zur Veranschaulichung als Momentaufnahme bzw. augenblickliche Zwischenpositionen dargestellt. Die Energieführungskette 1 ist für eine quasi ebene Bewegung entlang der Vorwärts- und Rückwärtsrichtung, d.h. mit parallel bleibenden Trumen 1A, 1B gestaltet und besteht im Wesentlichen aus Kettengliedern (nicht näher gezeigt) die z.B. um senkrecht zur Ebene der FIG.1-7 schwenkbare parallele Schwenkachsen gegeneinander abwinkelbar sind. Die Energieführungskette 1 kann bei allen Ausführungsformen in einer in FIG.1B schematisch näher gezeigten Führungsrinne 5 seitlich geführt sein.

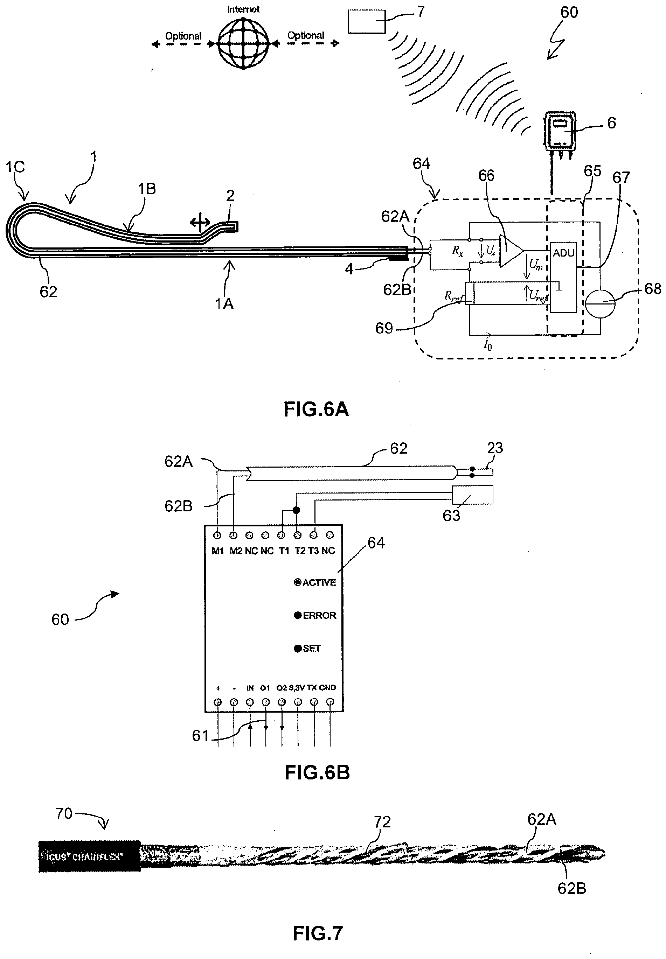

Einen seltenen aber besonders bei langen oder schnell fahrenden Energieführungsketten 1 möglichen Fehlerzustand (als "Blitz" angedeutet) zeigen hier rein schematisch und in übertriebener Darstellung nur FIG.1A und FIG.2A, wobei ein Teilbereich des beweglichen Trums 1B in unerwünschter Weise aufsteigt. FIG. 6A zeigt beispielhaft einen normalen Verlauf der Energieführungskette 1.

Im Ausführungsbeispiel nach FIG.1A-1B ist ein Überwachungssystem 10 mit einem entlang der beiden Trume 1A, 1B und durch den Umlenkbogen 1C der Energieführungskette 1 geführten elektrischen Indikatorleiter 12 als Kernelemente des Gebers gezeigt. Der einzige Indikatorleiter 12 ist als Dipolstrahler bzw. Dipolantenne angeordnet und lediglich am Endknoten an der Basis 2 mit einer Schaltung 14 verbunden. Die Schaltung 14 umfasst einen Signalgenerator der ein hochfrequentes Anregungssignal, z.B. ein Wechselstrom-Sinussignal mit einer Frequenz von einigen Mhz in den Indikatorleiter 12 speist. Ferner hat die Schaltung 14 einen SWR-Meter (nicht gezeigt), welcher anhand des Indikatorleiters 12 das Stehwellenverhältnis (SWR) als elektrische Größe erfasst. Das SWR ist von der Raumlage des Indikatorleiters 12 und damit der Energieführungskette 1, insbesondere des beweglichen Trums 1B abhängig. Die Erfassung des SWR erlaubt es, einen Fehlerzustand (als "Blitz" angedeutet) durch Vergleich mit einem bei Inbetriebnahme angelernten Sollverlauf des SWR (vgl. 30 in FIG.3) zu erkennen. Anstelle des SWR-Meter kann z.B. auch ein Netzwerkanalysator oder eine einfachere Schaltung für die Messung der reflektierten Welle bei gleichbleibender Anregungsfrequenz geeignet. Die Schaltung 14 ist ausgangsseitig mit einer Auswertungseinheit 6 verbunden, die z.B. ein das SWR anzeigendes Ausgangssignal der Schaltung 14 auswertet und bei Fehlerzustand frühzeitig einen Notstopp auslöst.

In der Variante nach FIG.2A-2B bildet der Indikatorleiter 22 eine Messschleife bzw. Schleifenantenne und ist als induktiver Teil eines RLC Schwingkreis in der Schaltung 24 angeordnet. Die beiden Endpunkte von zwei Messadern 22A, 22B an der Basis 2 sind unmittelbar mit den restlichen Komponenten des Schwingkreis der Schaltung 24 verbunden. Die distalen Endpunkte, z.B. am Mitnehmer 4, sind anhand einer niederohmigen Kurzschlusskomponente 23 kurzgeschlossen, wie in FIG.2B gezeigt. Da die Induktion auch hier geometrieabhängig ist, kann die Schaltung 24 eine Veränderung der Spuleninduktion der Messschleife als Messwert 30 im Vergleich zu einem Normalverlauf zwischen zwei Toleranzkurven 31, 32, wie in FIG.3 schematisch angedeutet erkennen. Dies kann durch einen Mikrocontroller 25 als Teil der Schaltung 24 oder in der Auswertungseinheit 6 erfolgen, z.B. durch Erkennen eines anormalen Sprungs in der erfassten elektrischen Größe des zweiteiligen Indikatorleiters 22.

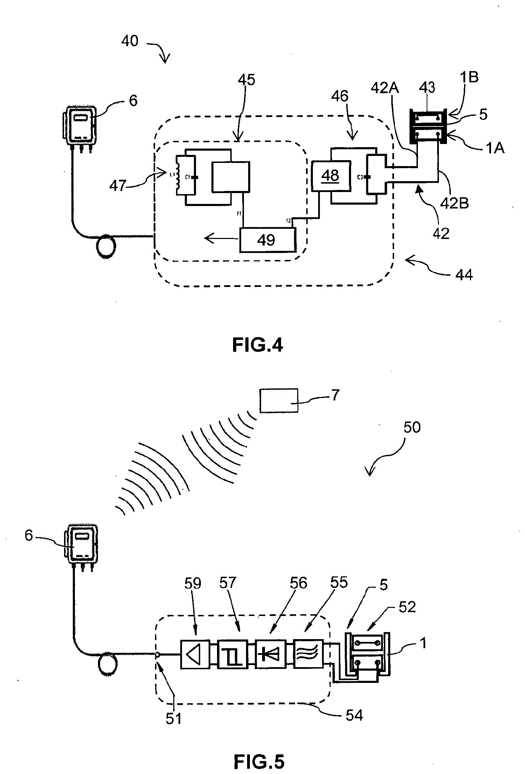

FIG.4 zeigt eine Variante des Überwachungssystems 40 zur Erfassung einer unerwarteten Veränderung in der Schwebungsfrequenz durch Überlagerung aus zwei Schwingkreisen. Der Indikatorleiter 42 bildet auch hier eine Schleife bzw. Spule aus zwei Messadern 42A, 42B, die von der Basis 2 bis zum Mitnehmer 4 in der Energieführungskette mitgeführt sind und am Mitnehmer durch die Kurzschlusskomponente 43 gebrückt sind.

Die Schaltung bildet einen ersten Messschwingkreis 46, mit einem Kondensator (C2) und der Messschleife 42 als Induktivität, der durch einen Signalgenerator 48 mit einem Sinussignal beaufschlagt wird. Ein Referenzschwingkreis 47 simuliert abhängig von einem Messlauf bzw. Teaching bei Inbetriebnahme das Normalverhalten des Messschwingkreis 46 bei bestimmungsgemäßen Verlauf der der Energieführungskette 1, wobei dessen Verhalten von der Position des Mitnehmers 4 abhängig ist. Die Simulation kann z.B. durch eine eingespeicherte Messwertfolge oder einen einstellbaren Oszillator in einem Mikrocontroller 45 realisiert werden. Anhand einer Mischerstufe 49 wird dann eine Schwebungsfrequenz ausgehend von der am Messschwingkreis 46 erfassten Schwingung und der lageabhängig simulierten Schwingung des Referenzschwingkreis 47 erzeugt. Anschließend erfolgt ein Vergleich der von der Mischerstufe 49 generierten bzw. simulierten Schwebungsfrequenz, z.B. mit einem von der Position X des Mitnehmers 4 abhängigen Toleranzfeld 31, 32 wie in FIG.3 schematisch gezeigt. Diese Variante ist, z.B. an das Prinzip eines Metalldetektors angelehnt, und kann insbesondere mit einer Führungsrinne 5 aus ferromagnetischem Stahlblech oder dgl. eingesetzt werden.

In einer nicht näher gezeigten Variante kann nebst der Messschleife aus den Messadern 42A, 42B auch eine separate Anregungs- bzw. Sendespule vorgesehen werden, z.B. nach dem Prinzip anderer Metalldetektortypen.

FIG.5 zeigt ein induktiv erfassendes weiteres Überwachungssystem 50 wobei die Führungsrinne 5 ähnlich eines "Ferritkerns" wirkt. Der schleifenförmige Indikatorleiter 52 wird durch einen Oszillator 55 als Signalgenerator angeregt und ausgemessen. Ein Demodulator 56 führt das erfasste Signal zu einem Diskriminator bzw. Hysterese-Komparator 57, und dieser weiter zu einer Endstufe, welche ein Ausgangssignal 51 für die Auswertungseinheit 6 bereitstellt. Angelernte Normalwerte bzw. Toleranzkurven 31, 32 können hierbei bei Inbetriebnahme oder über eine Datenverbindung wie z.B. WLAN mit einem Kommunikationsmodul 7 in die Auswertungseinheit 6 eingespeichert werden.

Die vorstehend beschriebenen Überwachungssysteme 10, 30, 40, 50 erlauben insbesondere anhand elektromagnetischer Wechselwirkung die Erkennung einer Lageabweichung der Energieführungskette 1 von ihrem nominalen Sollverlauf.

Nachfolgend wird ein unabhängiger weiterer Aspekt beschreiben, nämlich ein System 60 zur Verschleißüberwachung von elektrischen Leitern bzw. Adern in einem Versorgungskabel einer aktiven Energieführungskette um frühzeitig vor einem anstehenden Kabelbruch zu warnen.

Das Schaltungsmodul 64 verfügt über zwei Statusanzeigen z.B. (ACTIVE, ERROR: FIG.6B) und einen Taster (SET: FIG.6B) zum Einprogrammieren eines nominalen Widerstandswerts in ein Speicherregister in einem Mikrocontroller 65 des Schaltungsmoduls 64.

Ein Instrumenten- bzw. Differenzverstärker (OpAmp) 66 ist unmittelbar an die Endknoten von zwei Messadern 62A, 62B angeschlossen, die einen schleifenförmigen Indikatorleiter 62 in der Energieführungskette 1 bilden, der am Mitnehmer 4 über eine Komponente 23 kurzgeschlossen ist. Der Ausgang des Instrumentenverstärkers 66 ist mit dem Eingang eines A/D-Umsetzer-Block 67 im Mikrocontroller 65 verbunden, der an zwei weiteren Eingängen einen Spannung eines Referenzwiderstands 69 abgreift. Die in Serie geschalteten Messadern 62A, 62B sind mit dem Referenzwiderstands 69 (Rref) in Serie geschaltet und werden durch eine Referenz-Gleichstromquelle 68 (constant current source) des Schaltungsmoduls 64 mit einem konstanten Strom (I0) versorgt. Die Eingänge des ADU 67 erfassen einerseits die über die Messschleife 62A, 62B abfallende Messspannung um anhand des Stroms (I0) deren relativ kleinen ohmschen Serienwiderstand Rx zu bestimmen und andererseits nach dem Vierleiter-Messprinzip die Spannung am Referenzwiderstand 69 (Rref), aus deren Verhältnis der zu messende Widerstand Rx mit dem Mikrocontroller 65 präzise bestimmt wird.

Es können zur Steigerung der Erfassungssicherheit auch mehrere Messschleifen 62A, 62B jeweils über einen eigenen Differenzverstärker 66 und entsprechenden Eingang des ADU 67 ausgemessen werden. Alternativ zum Widerstandswert kann natürlich gleichwertig auch ein Leitwert ermittelt werden. An den Klemmen M1 und M2 (FIG.6B) des Schaltungsmoduls 64 wird die Messleitung, d.h. je ein proximaler Endknoten der Messadern 62A, 62B nahe der Basis 2, angeschlossen. Die beiden distalen Endknoten der Messadern 62A, 62B werden kurzgeschlossen bzw. niederohmig miteinander verbunden. Zu Normierungszwecken ist ein Temperatursensor 63 an das Schaltungsmodul 64 (Klemmen T2 und T3) angeschlossen.

Der Mikrocontroller 65 lässt die ACTIVE LED grün leuchten, sobald das Schaltungsmoduls 64 (über die Klemmen + und -) an eine Spannungsversorgung (z.B. 24V DC) angeschlossen wird und der Referenzwert einprogrammiert ist. Der Referenzwert wird bei Inbetriebnahme einmalig durch Betätigung des SET-Tasters in den Mikrocontroller 65 programmiert, durch intiale Messung über den Instrumentenverstärker 66 wie oben.

Die grüne und rote Error LED leuchten auf, sobald der vom Mikrocontroller 65 gemessene Widerstandswert Rx der Leitung einen vorbestimmten Warnschwellwert (z.B. 1,25 x Rx) überschritten hat. Der Warnschwellwert kann empirisch aus Lebensdauerversuchen ermittelt werden und ggf. auch nachträglich, z.B. über das Kommunikationsmodul 7 geändert bzw. aktualisiert werden. Ferner kann der Mikrocontroller 65 über einen Ausgang durch ein Relais (nicht gezeigt) einen Warnmeldekontakt (O1) schließen.

Wenn ein Kabelbruch aufgetreten ist (Rx gegen unendlich), geht z.B. die grüne LED aus und nur die rote Error LED leuchtet. Zusätzlich schließt der Mikrocontroller 65 dann einen weiteren potentialfreie Fehlerkontakt (O2).

Vorzugsweise wird die Warnmeldung über eine Kommunikationsschnittstelle z.B. ein Industriebus, RS-232 oder dgl. (3,3V, TX, GND) an die hier optionale Auswertungseinheit 6 oder unmittelbar an ein internetfähiges Kommunikationsmodul 7 übertragen werden.

Über die Kommunikationsschnittstelle (3,3V, TX, GND) des Schaltungsmoduls 64 kann der Mikrocontroller 65 erfasste Messdaten (Widerstandswert, Konstantstrom, Spannungsabfall, Temperatur etc.) an die optionale Auswertungseinheit 6 oder unmittelbar an das Kommunikationsmodul 7 übertragen. Das Schaltungsmodul 64 kann alternativ oder zusätzlich einen Datenlogger (z.B. für eine Mikro SD-Karte) zur Messdatenspeicherung aufweisen. Ferner können Sensoreingänge als Zyklenzähler bzw. zur Positionserfassung (z.B. nach FIG.1-5) vorgesehen sein. In der Programmierung des Mikrocontrollers 65 kann ein Softwarefilter realisiert sein, um Störeinflüsse z.B. durch elektormagnetische Wechselwirkung mit anderen aktiven Leitungen, herauszufiltern. Die Messung des Widerstands der Messadern 62A, 62B kann periodisch z.B. im Abstand von wenigen Minuten oder in quasizufälligen Zeitintervallen erfolgen um Artefakte z.B. durch Oberwellen und dgl. zu vermeiden.

FIG.7 zeigt rein beispielhaft zur Veranschaulichung wie Messadern 62A, 62B zusammen mit aktiven Versorgungsadern in einem Versorgungskabel 70 mitverseilt sind, wobei die Messadern 62A, 62B baugleich zu mindestens anderen im Betrieb aktiven Versorgungsadern sind.

### Bezugszeichenliste

FIG.1-6
   1 Energieführungskette
   1A Stationäres Trum
   1B Bewegliches Trum
   1C Umlenkbogen
   2 Festpunkt
   4 Mitnehmer
   5 Führungsrinne
   6 Auswertungseinheit
   7 Kommunikationsmodul
FIG.1A-1B
   10 Überwachungssystem
   11 Signal
   12 Indikatorleiter
   14 Schaltung
FIG.2A-2B
   20 Überwachungssystem
   22 Indikatorleiter
   22A, 22B Messader
   23 Kurzschlusskomponente
   24 Schaltung
   25 Mikrocontroller
   26 Schwingkreis
FIG.3
   X Position des Mitnehmers
   Y Betrag (der elektrischen Größe)
   30 Messwert (der elektrischen Größe)
   31 untere Toleranzkurve
   32 obere Toleranzkurve
FIG.4
   40 Überwachungssystem
   42 Indikatorleiter
   42A, 42B Messader
   43 Kurzschlusskomponente
   44 Schaltung
   45 Mikrocontroller
   46 Messschwingkreis
   47 Referenzschwingkreis (simuliert)
   48 Signalgenerator
   49 Mischerstufe
FIG.5
   50 Überwachungssystem
   51 Signal
   52 Indikatorleiter
   54 Schaltung
   55 Oszillator (Signalgenerator)
   56 Demodulator
   57 Komparator
   59 Endstufe
FIG. 6
   60 Überwachungssystem
   61 Signal
   62 Indikatorleiter (Rx)
   62A, 62B Messadern
   63 Tempertursensor
   64 Schaltungsmodul
   65 Mikrocontroller
   66 Differenzverstärker
   67 A/D-Umsetzer
   68 Stromquelle
   69 Referenzwiderstand (Rref)
FIG.7
   70 elektrisches Versorgungskabel
   72 aktive Adern
   62A, 62B Messadern

## Patentansprüche

1. Überwachungssystem zur Zustandsüberwachung eines Kabels (70) das in einer Energieführungskette (1) zwischen einer Basis und einem dazu relativbeweglichen Mitnehmer geführt ist, umfassend:
- eine Energieführungskette (1) die entlang eines Verfahrwegs verfahrbar ist und dabei ein bewegliches Trum (1B) mit einem Anschlussende für den Mitnehmer (4), ein ruhendes Trum (1A) mit einem Anschlussende für die Basis (2) und zwischen beiden Trumen einen Umlenkbogen (1C) bildet; und
- eine Überwachungsvorrichtung (60) mit mindestens einem an der Energieführungskette (1) angeordneten Geber (62), welche ein anhand des Gebers erzeugtes Signal (61) auswertet um zu überwachen, ob im Betrieb der Energieführungskette ein Fehlerzustand auftritt; **dadurch gekennzeichnet, dass**
- der Geber (62) zwei von der Energieführungskette geführte elektrische Indikatorleiter (62A, 62B) aufweist, die zumindest entlang einer überwiegenden Länge des beweglichen Trums (1B) verlaufen; und
- die Überwachungsvorrichtung (60) eine Schaltung mit einer Messeinrichtung (64) zur Widerstands- oder Leitwertmessung umfasst; und
- dass jeweils ein Endpunkt von jedem der beiden Indikatorleiter (62A, 62B) an einem Anschlussende (2) der Energieführungskette (1) mit der Messeinrichtung (64) verbunden ist und die jeweils anderen Endpunkte der Indikatorleiter, insbesondere an dem anderen Anschlussende (4) der Energieführungskette (1), kurzgeschlossen (23) sind, sodass die Leiter (62A, 62B) eine Messschleife bilden, deren Widerstands- oder Leitwert durch die Messeinrichtung (64) messbar ist.

2. Überwachungssystem nach Anspruch 1, **dadurch gekennzeichnet, dass** die Überwachungsvorrichtung (60) eine Auswertungseinheit (6) umfasst, die eine integrierte Logikschaltung und einen Referenzwertspeicher aufweist, wobei die Logikschaltung (65) ein Ausgangssignal der Messeinrichtung (64) erhält und zum Vergleich mit mindestens einem vorgespeicherten Referenzwert aus dem Referenzwertspeicher nutzt.

3. Überwachungssystem nach Anspruch 1 oder 2, insbesondere nach Anspruch 2, **dadurch gekennzeichnet, dass** für die bzw. jede Messschleife ein eigener separater Instrumentenverstärker (66) vorgesehen ist, welcher eingangsseitig den Endpunkten der Indikatorleiter (62A, 62B) verbunden ist, und ausgangsseitig mit einem Analog-Digital-Umsetzer (67), insbesondere einem in der Logikschaltung (65) integrierten Analog-Digital-Umsetzer, verbunden ist, und dass vorzugsweise in Serie zur Messschleife ein Referenzwiderstand (69) geschaltet ist, und eine Konstantstromquelle (68) einen Messstrom durch die Messschleife und ggf. Referenzwiderstand speist.

4. Überwachungssystem nach einem der Ansprüche 1 bis 3, **dadurch gekennzeichnet, dass** die Indikatorleiter als zwei zusätzliche Messadern (62A, 62B) in einem mehradrigen Versorgungskabel (70) mit aktiven Versorgungsadern (72) ausgeführt sind, wobei die Messadern vorzugsweise mittels einer Kurzschlusskomponente (23) am mitnehmerseitigen Anschlussende (4) kurzgeschlossen sind und am basisseitigen Ende (2) an die Messeinrichtung (64) angeschlossen sind.

5. Überwachungssystem nach Anspruch 4, **dadurch gekennzeichnet, dass** die Messadern (62A, 62B) zusammen mit den aktiven Versorgungsadern (72) im Versorgungskabel (70) verseilt oder verflochten sind, wobei die Messadern (62A, 62B) vorzugsweise baugleich zu mindestens einer aktiven Versorgungsader ausgeführt und entsprechend dieser verseilt oder verflochten sind.

6. Überwachungssystem nach einem der Ansprüche 1 bis 5, **dadurch gekennzeichnet, dass** die integrierte Logikschaltung (65) einen Bedieneingang zum Einspeichern eines bei Inbetriebnahme durch die Messeinrichtung (64) gemessenen Widerstands- oder Leitwerts als Referenzwert aufweist und/oder eine Warnmeldung auslöst, wenn der Widerstands- oder Leitwert des Indikatorleiters um einen vorbestimmten Betrag, insbesondere einen Betrag im Bereich von 15-25% des Referenzwerts, vom Referenzwert abweicht.

7. Überwachungssystem nach einem der Ansprüche 1 bis 6, **dadurch gekennzeichnet, dass** die Auswertungseinheit (6) einen Speicher für Anwendungsdaten aufweist, und eine Logik umfasst, welche das von der Schaltung ausgegebene Signal abhängig von gespeicherten Anwendungsdaten auswertet.

8. Überwachungssystem nach einem der Ansprüche 1 bis 7, **dadurch gekennzeichnet, dass** die Auswertungseinheit (6) eine Kommunikationsschnittstelle zur Verbindung mit einem übergeordneten System (7) umfasst.

9. Überwachungssystem nach einem der Ansprüche 1 bis 8, **dadurch gekennzeichnet, dass** die Überwachungsvorrichtung (60) einen Temperatursensor (63) zur Temperaturnormierung aufweist.

10. Überwachungssystem nach einem der Ansprüche 1 bis 9, **dadurch gekennzeichnet, dass** eine Logikschaltung (65) vorgesehen ist, insbesondere einen Mikrocontroller, ASIC, DSP oder dgl., welche die erfasste elektrische Größe digital verarbeitet, insbesondere zum Vergleich mit einem Referenzwert aus einem Referenzwertspeicher.

11. Überwachungssystem nach einem der Ansprüche 1 bis 10, **dadurch gekennzeichnet, dass** die Schaltung (64) im laufenden Betrieb der Energieführungskette zeitkontinuierlich oder zeitdiskret die elektrische Größe erfasst und ein Filter, insbesondere ein Mittelwert- oder Spitzenfilter, in der Schaltung (64) oder der Auswertungseinheit (6) vorgesehen ist.

12. Überwachungssystem nach einem der Ansprüche 1 bis 11, **dadurch gekennzeichnet, dass** die Überwachungsvorrichtung (60) als Modul ortsfest an der Basis (2) angeordnet ist und der bzw. die Indikatorleiter (62A, 62B) einseitig am Anschlussende für die Basis an die Schaltung (64) angeschlossen ist bzw. sind.

13. Verwendung eines Überwachungssystems (60) nach einem der Ansprüche 1 bis 12, zur Zustandsüberwachung eines Daten- oder Stromversorgungskabels (70) einer Energieführungskette (1) im laufenden Betrieb, insbesondere zwecks präventiver Wartung.

## Claims

1. A monitoring system for monitoring the condition of a cable (70), which is guided in an energy guide chain (1) between a base and a moving end movable relative thereto, comprising:
- an energy guide chain (1) which is displaceable along a travel path and, in so doing, forms a mobile run (1B) with a connection end for the moving end (4), a stationary run (1A) with a connection end for the base (2) and a deflection arc (1C) between the two runs; and
- a monitoring device (60) with at least one sensor unit (62) arranged on the energy guide chain (1), which monitoring device evaluates a signal (61) generated using the sensor unit in order to monitor the occurrence of a fault condition during operation of the energy guide chain,
**characterized in that**
- the sensor unit (62) includes two electrical indicator conductors (62A, 62B) guided by the energy guide chain, which indicator conductors run at least along the greater part of the length of the mobile run (1B), and
- the monitoring device (60) comprises a circuit with a measurement device (64) for measuring resistance or conductance, and
- **in that** in each case one end point of each of the two indicator conductors (62A, 62B) is connected at one connection end (2) of the energy guide chain (1) to the measurement device (64) and the respective other end points of the indicator conductors, in particular at the other connection end (4) of the energy guide chain (1), are short-circuited (23), such that the conductors form (62A, 62B) a measurement loop, the resistance or conductance of which is measurable by the measurement device (64).

2. The monitoring system according to Claim 1, **characterized in that** the monitoring device (60) comprises an evaluation unit (6) which includes an integrated logic circuit and a reference value memory, wherein the logic circuit (65) receives an output signal from the measurement device (64) and uses it for comparison with at least one prestored reference value from the reference value memory

3. The monitoring system according to Claim 1 or 2, in particular according to Claim 2, **characterized in that** the or each measurement loop (66) is provided with its own separate instrumentation amplifier, which is connected on the input side to both end points of the indicator conductors (62A, 62B), and on the output side to an analogue-digital converter (67), in particular an analogue-digital converter integrated into the logic circuit (65), and **in that** a reference resistor (69) is preferably connected in series to the measurement loop and a constant-current source (68) feeds a measurement current through the measurement loop and optionally the reference resistor.

4. The monitoring system according to one of Claims 1 to 3, **characterized in that** the indicator conductors are embodied as two additional measurement cores (62A, 62B) in a multicore supply cable (70) with active supply cores (72), wherein the measurement cores are preferably short-circuited (23) using a short-circuit component at the moving end connection end (4) and at the base end (2) are connected to the measurement device (64).

5. The monitoring system according to Claim 4, **characterized in that** the measurement cores (62A, 62B) are twisted together or braided together with the active supply cores (72) in the supply cable (70), wherein the measurement cores (62A, 62B) are preferably of like construction to at least one active supply core and are twisted or braided in a similar manner thereto.

6. The monitoring system according to one of Claims 1 to 5, **characterized in that** the integrated logic circuit (65) has an operator (64) input for inputting a resistance or conductance measured on start-up by the measurement device as reference value and/or triggers a warning signal when the resistance or conductance of the indicator conductor differs from the reference value by a predetermined amount, in particular an amount in the range from 15-25% of the reference value.

7. The monitoring system according to one of Claims 1 to 6, **characterized in that** the evaluation unit (6) includes a memory for application data and comprises a logic circuit which evaluates the signal output by the circuit in dependence on stored application data.

8. The monitoring system according to one of Claims 1 to 7, **characterized in that** the evaluation unit (6) comprises a communication interface for connection to a higher-level system (7).

9. The monitoring system according to one of Claims 1 to 8, **characterized in that** the monitoring device (60) includes a temperature sensor (63) for temperature normalization.

10. The monitoring system according to one of Claims 1 to 9, **characterized in that** a logic circuit (65) is provided, in particular a microcontroller, ASIC, DSP or the like, which digitally processes the detected electrical quantity, in particular for comparison with a reference value from a reference value memory.

11. The monitoring system according to one of Claims 1 to 10, **characterized in that**, in ongoing operation (64) of the energy guide chain, the circuit detects the electrical quantity continuously or in time-discrete manner and a filter, in particular an average or peak filter, is provided in the circuit (64) or the evaluation unit (6).

12. The monitoring system according to one of Claims 1 to 11, **characterized in that** the monitoring device (60) is arranged as a module stationarily on the base (2) and the indicator conductor(s) (62A, 62B) is/are connected single-endedly to the circuit (64) at the connection end for the base.

13. Use of a monitoring system (60) according to one of Claims 1 to 12, for monitoring the condition of a data or power supply cable (70) of an energy guide chain (1) in ongoing operation, in particular for the purpose of preventive maintenance.

## Revendications

1. Système de surveillance pour surveiller l'état d'un câble (70) qui est guidé dans une chaîne de guidage d'énergie (1) entre une base et un entraîneur qui est mobile par rapport à celle-ci, comprenant:
- une chaîne de guidage d'énergie (1) qui est mobile le long d'un chemin de déplacement et forme ainsi un brin mobile (1B) avec une extrémité de connexion pour l'entraîneur (4), un brin au repos (1A) avec une extrémité de connexion pour la base (2) et un coude de déflexion (1C) entre les deux brins; et
- un dispositif de surveillance (60) avec au moins un capteur (62) disposé sur la chaîne de guidage d'énergie (1), capteur qui évalue un signal (61) généré au moyen du capteur afin de surveiller si une condition de défaut se produit dans le fonctionnement de la chaîne de guidage d'énergie; **caractérisé en ce que**
- le capteur (62) comprend deux conducteurs électriques indicateurs (62A, 62B) guidés par la chaîne de transmission de l'énergie et s'étendant au moins sur une longueur majeure du brin mobile (1B); et
- ledit moyen de surveillance (60) comprend un circuit ayant un dispositif de mesure (64) pour mesurer la résistance ou la conductance; et **en ce que**
- un point d'extrémité respectif de chacun des deux conducteurs indicateurs (62A, 62B) est relié à une extrémité de raccordement (2) de la chaîne de guidage d'énergie (1) au dispositif de mesure (64) et les autres points d'extrémité respectifs des conducteurs indicateurs sont court-circuités, en particulier à l'autre extrémité de raccordement (4) de la chaîne de guidage d'énergie (1), de sorte que les conducteurs (62A, 62B) forment une boucle de mesure dont la valeur de résistance ou de conductance peut être mesurée par le dispositif de mesure (64).

2. Système de surveillance selon la revendication 1, **caractérisé en ce que** le dispositif de surveillance (60) comprend une unité d'évaluation (6) ayant un circuit logique intégré et une mémoire de valeurs de référence, le circuit logique (65) recevant un signal de sortie du dispositif de mesure (64) et l'utilisant pour la comparaison avec au moins une valeur de référence pré-mémorisée de la mémoire de valeurs de référence.

3. Système de surveillance selon la revendication 1 ou 2, en particulier selon la revendication 2, **caractérisé en ce que** la ou chaque boucle de mesure est munie de son propre amplificateur de mesure (66) séparé, qui est relié du côté entrée aux points terminaux des conducteurs indicateurs (62A, 62B) et du côté sortie à un convertisseur numérique-analogique (67), en particulier un convertisseur analogique-numérique intégré dans le circuit logique (65), et **en ce qu'**une résistance de référence (69) est de préférence montée en série avec la boucle de mesure et une source de courant constant (68) alimente un courant de mesure à travers la boucle de mesure et, le cas échéant, la résistance de référence.

4. Système de surveillance selon l'une quelconque des revendications 1 à 3, **caractérisé en ce que** les conducteurs indicateurs sont conçus comme deux fils de mesure supplémentaires (62A, 62B) dans un câble d'alimentation à plusieurs fils (70) avec des fils d'alimentation actifs (72), les fils de mesure étant court-circuités de préférence au moyen d'un composant de court-circuit (23) à l'extrémité de raccordement (4) côté conducteur et étant reliés au dispositif de mesure (64) à l'extrémité (2) côté base.

5. Système de surveillance selon la revendication 4, **caractérisé en ce que** les fils de mesure (62A, 62B) sont toronnés ou tressés ensemble avec les fils d'alimentation actifs (72) dans le câble d'alimentation (70), les fils de mesure (62A, 62B) étant de préférence conçus pour être identiques dans leur construction à au moins un fil d'alimentation actif et étant toronnés ou tressés conformément à celui-ci.

6. Système de surveillance selon l'une quelconque des revendications 1 à 5, **caractérisé en ce que** le circuit logique intégré (65) comporte une entrée de commande pour mémoriser une valeur de résistance ou de conductance mesurée par le dispositif de mesure (64) lors de la mise en service en tant que valeur de référence et/ou déclenche un message d'alerte si la valeur de résistance ou de conductance du conducteur indicateur s'écarte de la valeur de référence d'une quantité prédéterminée, en particulier d'une quantité comprise entre 15 et 25 % de la valeur de référence.

7. Système de surveillance selon l'une quelconque des revendications 1 à 6, **caractérisé en ce que** l'unité d'évaluation (6) comprend une mémoire pour les données d'application et comprend une logique qui évalue le signal émis par le circuit en fonction des données d'application stockées.

8. Système de surveillance selon l'une quelconque des revendications 1 à 7, **caractérisé en ce que** l'unité d'évaluation (6) comprend une interface de communication pour la connexion à un système de niveau supérieur (7).

9. Système de surveillance selon l'une quelconque des revendications 1 à 8, **caractérisé en ce que** le dispositif de surveillance (60) comprend un capteur de température (63) pour la normalisation de la température.

10. Système de surveillance selon l'une quelconque des revendications 1 à 9, **caractérisé en ce qu'**il est prévu un circuit logique (65), en particulier un microcontrôleur, un ASIC, un DSP ou similaire, qui traite numériquement la grandeur électrique détectée, en particulier pour la comparaison avec une valeur de référence provenant d'une mémoire de valeurs de référence.

11. Système de surveillance selon l'une quelconque des revendications 1 à 10, **caractérisé en ce que** le circuit (64) détecte la grandeur électrique de manière continue ou discrète dans le temps pendant le fonctionnement continu de la chaîne de guidage d'énergie, et **en ce qu'**un filtre, en particulier un filtre de valeur moyenne ou un filtre de crête, est prévu dans le circuit (64) ou dans l'unité d'évaluation (6).

12. Système de surveillance selon l'une quelconque des revendications 1 à 11, **caractérisé en ce que** le dispositif de surveillance (60) est disposé en tant que module de manière fixe sur la base (2) et le ou les conducteurs indicateurs (62A, 62B) est ou sont reliés au circuit (64) d'un côté à l'extrémité de raccordement pour la base.

13. Utilisation d'un système de surveillance (60) selon l'une quelconque des revendications 1 à 12, pour surveiller l'état d'un câble de données ou d'alimentation en courant électrique (70) d'une chaîne de guidage d'énergie (1) pendant le fonctionnement, en particulier à des fins de maintenance préventive.
